# EUROPEAN PATENT SPECIFICATION

(11) **EP 2 637 865 B1**
(45) Date of publication and mention of the grant of the patent: **15.01.2014**
(21) Application number: 11778919.8
(22) Date of filing: 07.11.2011
(51) Int. Cl.: B32B 27/04, F21K 99/00

(54) **FLEXIBLE LAMINATED SHEET OR STRIP INCORPORATING SMALL LIGHT SOURCES**
FLEXIBLE BESCHICHTETE FOLIE ODER STREIFEN MIT KLEINEN LICHTQUELLEN
FEUILLE OU UNE BANDE STRATIFIÉE SOUPLE INCORPORANT DE PETITES SOURCES LUMINEUSES

(30) Priority: 12.11.2010 IT AN20100199
(43) Date of publication of application: 18.09.2013
(73) Proprietor: Powerplast S.r.l., 60100 Ancona (IT)
(72) Inventor: GHERARDI, Alessandro, I-60127 Ancona (IT); TIMPANARI, Piermario Raimondo, I-60131 Ancona (IT); RECANATINI, Francesco, 60021 Camerano (an) (IT)
(74) Representative: Baldi, Claudio
(86) International application number: PCT/EP2011/069540
(87) International publication number: WO 2012/062701

(56) References cited:
- WO-A1-01/05205
- DE-A1-102007 039 416
- DE-U1-202005 018 159

## Description

The present patent application for industrial invention relates to a flexible laminated sheet or strip incorporating small light sources.

The peculiarities and advantages of the invention will become more evident further to a short description of the prior art.

Sheets made of fabric or plastic laminate provided with small light sources of different type, such as low voltage, high voltage, fluorescence or phosphorescence light sources, have been available on the market for long.

According to a preferred embodiment said light sources consist in LED strips, which are commonly found on the market, firmly applied on the visible side of said sheet. Said LED strips are provided with adhesive back side to ensure easy application on the sheet surface.

Said sheets have two possible uses, meaning that they can be alternatively used in enclosed environments or in outdoor spaces, possibly as sun shades for shops or homes, roofs and walls for gazebos or other prefabricated structures, boat sails, etc.

When such a sheet is used in outdoor spaces, said LED strips must be protected against humidity to prevent them from rapidly losing their efficiency.

The solution that is currently used consists in providing the front of each LED strip with a silicone protection coating, which is basically transparent and becomes semi-rigid after setting. Such an operating solution is not satisfactory. In fact, the presence of said silicone coating on the LED strip tends to considerably stiffen the structure of the entire sheet, making it difficult, if not impossible, to roll up and fold the sheet.

Moreover, being adapted to protrude considerably on the surface of the sheet, said light sources are directly exposed to the risk of shocks and violent abrasion, which may cause their traumatic detachment after a prolonged use of the sheet.

To prevent such a risk, another type of illuminated sheets is known, being characterized by the fact that the LED strips provided with silicone coatings are covered with a layer of fabric or plastic laminate that is molded in such manner that each of said strips is engaged in the concavity of a corresponding rib of the coating, similar to a "pocket".

Additionally, it must be considered that the techniques and materials that have been used so far for the execution of a similar operating process cannot avoid the formation of a free space between each of said LED strips and the pocket containing it. As a matter of fact, the longitudinal edges of said pockets are sewn or glued to the support layer in external position with respect to the corresponding longitudinal edges of the LED strips. In view of the above, each of said coating pockets is never able to strictly and exactly adhere to the LED strip, or better said, to the silicone coating used to protect the LED strip. The lack of adhesion is the cause of considerable drawbacks in the sheets obtained with this manufacturing process.

A pocket that does not adhere to the LED strip still needs the presence of the semi-rigid silicone protective layer. In fact, such a pocket is poorly protective, especially for light sources provided with considerable thickness, in case of shocks and abrasions that may indirectly affect the LED strip contained inside it. Also in the case when such a pocket houses a strip with light sources provided with very low thickness - and consequently less exposed to accidental shocks - the presence of the silicone coating would still be necessary.

As it is known, very thin light sources (such as light sources known as IP20) suffer from humidity and therefore must be hermetically sealed. Such a hermetic insulation can be provided only by said silicone coatings and not by the fabric or plastic laminate used to make the pockets designed to house the LED strips.

Moreover, it must be considered that sheets of known type with silicone coatings of LED strips are not easy to roll up and fold, because the silicone coating is excessively rigid. Moreover, in sheets of known type it is impossible to obtain a strict, exact adhesion between one of said "coating" pockets and the corresponding LED strip.

Additionally, the fabric or plastic laminate used for the pockets is certainly able to screen the light coming from the LED strips, thus impairing the lighting effect they should produce. In order not to impair the lighting effect, the pockets must be made of a transparent material to allow transmission of the light generated by the LED strips.

Nevertheless, the use of such a transparent material on the light sources disposed on the sheet makes said light sources permanently visible for the observer, also when they are not turned on. Such a direct visibility of the light sources is extremely improper, not only because it impairs the general aesthetical appearance of the sheet, but also because it impairs the pleasant surprise generated for the observer when discovering that a sheet that seemed to be a totally "normal" sheet is suddenly able to generate a luminous ornamental effect.

DE10 2007 039416 discloses a luminous panel comprising a LED strip disposed between two plates of rigid plastic material, of which one is a transparent plate, with adhesive applied on LEDs and between the two plates. It must be noted that said panel is rigid, it cannot be rolled up and LEDs are visible for the observer.

DE20 2005 018159 discloses a luminous panel comprising luminescent elements disposed between two rigid laminated transparent plates by means of a thermoplastic film or resin. Also in this case, the panel is rigid, it cannot be rolled up and LEDs are visible for the observer.

WO 01/05205 discloses a flexible laminate to encapsulate a device. In particular, the device comprises OLEDs (organic LEDs) formed on a flexible substrate.

The specific purpose of the present invention is to optimize the realization modes of a sheet incorporating a plurality of small light sources and, more precisely, to overcome the aforementioned drawbacks of the prior art.

Such a sheet is designed for outdoor uses in which the light sources are efficaciously protected against humidity and potential shocks, without the semi-rigid silicone coatings that are typical of the prior art.

According to such an innovative technology, light sources without silicone protection are fixed on the front of a support layer made of fabric or plastic laminate, which represents the bearing structure of the sheet. Then, the light sources are covered with a coating layer, likewise made of fabric or plastic laminate, after interposition of a suitable adhesive layer.

Said coating layer must carefully adhere to the adhesive layer applied on the light sources, in order to form a "multilayer compact assembly", composed - from outside of the sheet to inside - of coating layer, adhesive layer, light source and support layer.

In view of the above, no free space or undesired "clearance" is formed between each light source and its corresponding coating layer. This, together with the fact that said adhesive layer practically seals the light sources, guarantees that the light sources are perfectly protected against humidity, without the presence of a specific silicone protection.

Moreover, the stable insertion of the light sources in the thickness of the multilayer structure of the sheet of the invention guarantees a substantial safety of the light sources (meaning the capacity of avoiding a traumatic detachment from the sheet) also with respect to potential shocks or accidental abrasions.

It is worthless saying that the total renunciation to traditional semi-rigid silicone coatings has provided the sheet of the invention with an extremely soft "moldable" structure that can be folded or rolled up without any problem.

A further peculiarity of the new technology of the invention is represented by the fact that the strict adhesion provided between said coating layer and the light sources guarantees that the light generated by the latter is perfectly visible through the coating, also in case of non-transparent coating.

The fact that said light sources can be mounted under a non-transparent coating layer permits to hide the light sources perfectly and prevent people observing the sheet obtained according to the process of the invention from noticing the internal presence of said light sources until they are turned on or seen against the light.

In addition to the aforementioned advantages, the sheet obtained according to the new technology is also appreciated for the fact that, if necessary, it can be provided with an efficacious internal reinforcement structure obtained by inserting the electrical connections of the light sources in the thickness of the sheet. This can be achieved by making said electrical connections of carbon fiber, titanium fiber or equivalent materials.

For explanatory reasons, the description of the invention continues with reference to attached drawings, which only have an illustrative, not limiting value, wherein:
- fig. 1 is an axonometric view of a section of the support layer of the sheet obtained with the process of the invention, with light sources but without coating layer;
- fig. 2A is an exploded drawing of the composite structure of a first embodiment of the sheet of the invention;
- fig. 3A is the "compact" version of fig. 2A and practically consists in a section of the sheet of the invention;

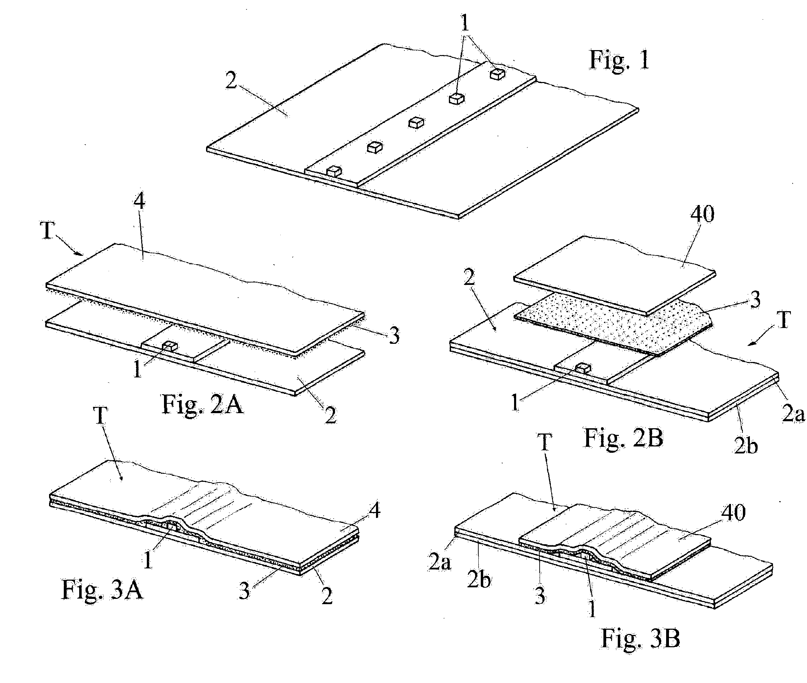

- fig. 2B is an exploded drawing of the composite structure of a second embodiment of the sheet of the invention;
- fig. 3B is the "compact" version of fig. 2B and practically consists in a section of the sheet.

Referring to the aforementioned figures, the sheet or strip of the invention is disclosed, being generally indicated as (T). While the following description makes specific reference to a sheet, it is understood that the scope of the invention is also extended to a narrow strip.

The sheet (T) comprises:
- a flexible non-transparent support layer (2);
- a plurality of light sources (1) disposed on the support layer (2);
- a flexible coating layer (4; 40) disposed on the support layer (2) in such manner to cover the light sources (1); and
- an adhesive layer (3) interposed between the coating layer and the support layer, in such manner that the coating layer (4; 40) adheres on the support layer (2) and on the light sources (1) without leaving air gaps.

The coating layer (4, 40) is made of non-transparent material that allows transmission of light, in such manner that the light sources are not visible for the observer when they are turned off and the luminous effect of the light sources is perceived when they are turned on.

The light sources (1) are preferably LEDs or LED strips, but they can also be of fluorescence or phosphorescence type.

The support layer (2) and the coating layer (4) can be of fabric or plastic laminate.

In case of small strips, suitable fixing means, such as Velcro, can be applied under the support layer (2).

The adhesive (3) is a humidity-proof adhesive.

The realization method of the sheet (T) provides for the sequential execution of the following operating steps:
a) the light sources (1) and their electrical connections are fixed on the support layer (2);
b) the coating layer (4, 40) is fixed to the support layer (2) with the interposition of the adhesive layer (3) in such manner to perfectly adhere to the light sources (1).

It must be noted, however, that different solutions can be adopted starting from a similar general idea.

Referring to the execution of step a) - as expressly shown in fig. 1-said light sources (1) are preferably composed of a LED strip and said support layer (2) is preferably formed of a plastic film.

Likewise, the support layer (2) can be provided with a composite, or multilayer structure, being formed of two or more irreversibly joined sheets of fabric or plastic laminate. Referring to fig. 2B, the two sheets of said support layer (2) are indicated with numerals (2a, 2b). Such a composite structure is provided to give greater carrying capacity to said support layer (2) of the sheet (T).

The light sources (1) fixed on said support layer (2) can alternatively be LEDs, electroluminescent wires, fiber optics and similar devices, whereas electrical connections can be alternatively obtained with carbon fibers, titanium fibers, etc., capable of generating a reinforcement mesh inside the structure of the sheet of the invention (T).

Referring to step b) of the process of the invention, according to a first embodiment, the coating layer (4) has a continuous surface that substantially corresponds to the surface of the support layer (2), as shown in fig. 2A. In such a case, the adhesive layer (3) adapted to ensure adhesion of the coating layer (4) on the light sources (1) is applied in correspondence of the entire back side of the coating layer (4). In view of the above, the adhesive layer (3) is also adapted to provide mutual stable adhesion between the complete back of the coating layer (4) and the complete front of the support layer (2).

Alternatively, said coating layer (40) does not cover the entire support layer (2), and selectively covers only the light sources (1) already mounted on the front of the support layer, with the provision of the intermediate adhesive layer (3). As shown in fig. 2B, the coating layer is discontinuous, practically being a series of coating strips (40) basically corresponding to the profile and direction of the light sources. Each coating strip (40) has width higher than the corresponding light source (1). The above is necessary in order to have the longitudinal edges of the light source (1) exactly engaged and fixed to said support layer (2) at the two sides of the led strip (5).

Referring to figs. 3A and 3B, in both cases the sheet (T) obtained according to the process of the invention is provided with a compact multilayer structure, wherein the coating layer (4, 40), adhesive layer (3), light sources (1) and support layer (2) strictly adhere.

Regardless of the two aforementioned alternative embodiments of the coating layer (4, 40), adhesion of the coating layer to the support layer (2), which takes into account the need to coat also the light sources (1), can be obtained according to alternative modes that are capable of achieving the expected result.

A first option consists in the vacuum adhesion of the support layer (2) and coating layer (4, 40) with interposition of an adhesive layer (3) obtained with hot or cold reactivable glue with catalyst or exposure to UV radiation.

According to a second option, adhesion of the support layer (2) to the coating layer (4, 40) is obtained without vacuum, by simply pressing the two layers after application between them of an adhesive layer (3) reactivable with exposure to air or light.

Moreover, it is reiterated that the structure of the sheet (T) obtained according to the process of the invention can be advantageously reinforced by electrical connections - suitably made of carbon fibers, titanium fibers or similar materials - powering said light sources (1). Said electrical connections allow for obtaining a sort of reinforcement mesh incorporated in the thickness of the sheet of the invention. The position of said reinforcement mesh can be selected according to the specific configuration given to the sheet (T) from time to time.

When the sheet (T) is provided with a coating layer (4) with continuous surface, as shown in figs. 2A and 3A, said electrical and reinforcement connections (not shown in the enclosed figures) are housed in intermediate position between said coating layer (4) and the support layer (3).

Evidently, such a solution cannot be used when the sheet (T) is provided with a discontinuous coating layer (40), of the type shown in figs. 2B and 3B. In such a case, said mesh of electrical and reinforcement connections can find an advantageous application inside the support layer (2), as long as provided with the composite or multilayer structure shown in figs. 2B and 3B.

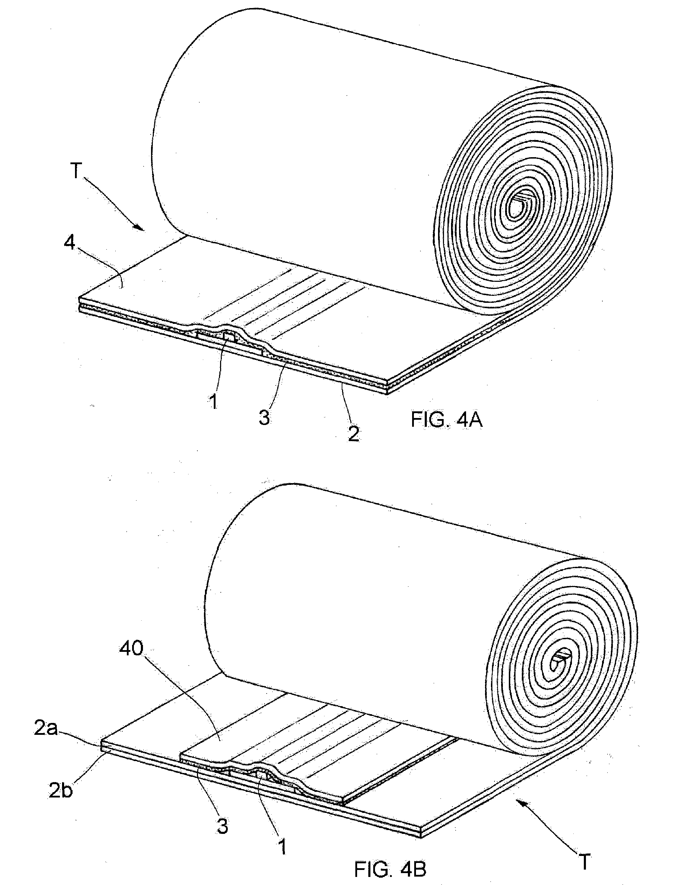

As shown in Figs. 4A and 4B, by using a thin adhesive layer (3) instead of silicone, the sheet (T) can be easily folded and rolled up, without forming wrinkles in correspondence of the light sources (1).

## Claims

1. Flexible laminated sheet or strip (T) incorporating small light sources (1), comprising:
- a support layer (2) made of fabric or plastic laminate;
- a plurality of light sources (1) disposed on said support layer (2);
- a coating layer (4; 40) made of fabric or plastic laminate disposed on said support layer (2) to cover said light sources (1); and
- a humidity-proof adhesive layer (3) interposed between said coating layer and support layer, so that the coating layer (4; 40) adheres on coating layer (2) and light sources (1) without air gaps,
**characterized by** the fact that
said support layer (2) and coating layer (4) are made of flexible materials in such manner to roll up the sheet (T) in a roll without wrinkles,
said support layer (2) is of non-transparent material, and
said coating layer (4, 40) is of a non-transparent material that allows transmission of light so that the light sources are not seen by an observer when said light sources are turned off and the observer can perceive the lighting effect of the light sources when the light sources are turned on.

2. Sheet (T) according to claim 1, **characterized by** the fact that said support layer (2) has a multilayer structure (2a, 2b).

3. Sheet (T) according to one of the preceding claims, **characterized by** the fact that said light sources (1) are LEDs.

4. Sheet (T) according to one of claims 1 or 2, **characterized by** the fact that said light sources (1) are fiber optics.

5. Sheet (T) according to one of claims 1 or 2, **characterized by** the fact that said light sources (1) are electroluminescent wires.

6. Sheet (T) according to one of the preceding claims, **characterized by** the fact that said coating layer (4) has a continuous surface that substantially corresponds to the surface of the support layer (2) against which it must adhere.

7. Sheet (T) according to one of claims 1 to 5, **characterized by** the fact that said coating layer (40) has a discontinuous surface, such that it selectively covers only said light sources (1) fixed on the support layer (2).

8. Sheet (T) according to one of the preceding claims, **characterized by** the fact that said light sources (1) have electrical connections consisting in carbon or titanium fibers, forming a reinforcement mesh for said sheet (T).

9. Sheet (T) according to one of the preceding claims, **characterized by** the fact that said light sources (1) have electrical connections incorporated between said coating layer (4) and support layer (2).

10. Sheet (T) according to claim 9, when depending on claim 2, **characterized by** the fact that said light sources (1) have electrical connections incorporated in the multilayer structure of the support layer (2).

11. Sheet (T) according to one of the preceding claims, **characterized by** the fact that said adhesive layer (3) comprises hot or cold reactivable glues with catalyst or exposure to UV radiation.

12. Sheet (T) according to one of claims 1 to 10, **characterized by** the fact that said adhesive layer (3) is a glue reactivable with exposure to air or light.

13. Sheet (T) according to one of the preceding claims, **characterized by** the fact that it comprises fixing means, such as Velcro, disposed on the back of said support layer (2) to fix said sheet or strip.

## Patentansprüche

1. Flexible Verbundfolie oder -streifen (T) aufnehmend eine Lichtquelle (1), umfassend:
- eine Tragschicht (2) aus Gewebe oder Kunststofflaminat;
- eine Vielzahl von Lichtquellen (1), die auf der Tragschicht (2) angeordnet sind;
- eine Deckschicht (4; 40) aus Gewebe oder Kunststofflaminat, die auf der Tragschicht (2) angeordnet ist, um die Lichtquellen (1) zu bedecken; und
- eine feuchtigkeitsbeständige Klebeschicht (3), die zwischen der Deckschicht und der Tragschicht so eingefügt ist, dass die Deckschicht (4; 40) auf der Tragschicht (2) und den Lichtquellen (1) haftet, ohne Luftspalte zu bilden,
**dadurch gekennzeichnet, dass**
die Tragschicht (2) und die Deckschicht (4) aus flexiblen Materialien so hergestellt sind, dass die Folie (T) zu einer faltenfreien Rolle aufgerollt werden kann,
die Tragschicht (2) aus einem nichttransparenten Material hergestellt ist und
die Deckschicht (4; 40) aus einem nichttransparenten, aber lichtdurchlässigen Material so hergestellt ist, dass die Lichtquellen für den Betrachter nicht sichtbar sind, wenn die Lichtquellen ausgeschaltet sind und der Betrachter den Beleuchtungseffekt der Lichtquellen wahrnehmen kann, wenn die Lichtquellen eingeschaltet sind.

2. Folie (T) nach Anspruch 1, **dadurch gekennzeichnet, dass** die Tragschicht (2) einen mehrschichtigen Aufbau (2a, 2b) besitzt.

3. Folie (T) nach einem der vorstehenden Ansprüche, **dadurch gekennzeichnet, dass** die Lichtquellen (1) aus LEDs bestehen.

4. Folie (T) nach Anspruch 1 oder 2, **dadurch gekennzeichnet, dass** die Lichtquellen (1) aus Lichtwellenleitern bestehen.

5. Folie (T) nach Anspruch 1 oder 2, **dadurch gekennzeichnet, dass** die Lichtquellen (1) aus Elektrolumineszenzdrähten bestehen.

6. Folie (T) nach einem der vorstehenden Ansprüche, **dadurch gekennzeichnet, dass** die Deckschicht (4) eine durchgehende Oberfläche besitzt, die im Wesentlichen der Fläche der Tragschicht (2) entspricht, auf der sie haften soll.

7. Folie (T) nach einem der Ansprüche 1 bis 5, **dadurch gekennzeichnet, dass** die Deckschicht (40) eine solche diskontinuierliche Oberfläche besitzt, dass wahlweise nur die Lichtquellen (1) bedeckt sind, die auf der Tragschicht (2) befestigt sind.

8. Folie (T) nach einem der vorstehenden Ansprüche, **dadurch gekennzeichnet, dass** die Lichtquellen (1) elektrische Anschlüsse bestehend aus Kohlenstoff- oder Titanfasern besitzen, die ein Armierungsgewebe für die Folie (T) bilden.

9. Folie (T) nach einem der vorstehenden Ansprüche, **dadurch gekennzeichnet, dass** die Lichtquellen (1) Elektroanschlüsse besitzen, die zwischen der Deckschicht (4) und der Tragschicht (2) eingebettet sind.

10. Folie (T) nach Anspruch 9, wenn abhängig von Anspruch 2, **dadurch gekennzeichnet, dass** die Lichtquellen (1) Elektroanschlüsse besitzen, die in den mehrschichtigen Aufbau der Tragschicht (2) eingebettet sind.

11. Folie (T) nach einem der vorstehenden Ansprüche, **dadurch gekennzeichnet, dass** die Klebeschicht (3) Klebstoffe umfasst, die heiß oder kalt mittels Katalysator oder UV-Lichtbestrahlung reaktivierbar sind.

12. Folie (T) nach einem der Ansprüche 1 bis 10, **dadurch gekennzeichnet, dass** die Klebeschicht (3) ein Klebstoff ist, der durch Luft- oder Lichtexposition reaktivierbar ist.

13. Folie (T) nach einem der vorstehenden Ansprüche, **dadurch gekennzeichnet, dass** er Befestigungsmittel, wie etwa Klettverschlussband umfasst, das auf der Rückseite der Tragschicht (2) angeordnet ist, um die Folie oder den Streifen zu befestigen.

## Revendications

1. Lé ou bande laminée flexible (T) incorporant des sources lumineuses (1), comprenant :
- une couche de support (2) en tissu ou laminé plastique ;
- une pluralité de sources lumineuses (1) disposées sur le substrat de support (2) ;
- une couche de couverture (4; 40), en tissu ou laminé plastique, disposée sur la couche de support (2) de manière à couvrir les sources lumineuses (1) ; et
- une couche adhésive (3) étanche à l'humidité interposée entre la couche de couverture et la couche de support, de manière à ce que la couche de couverture (4; 40) adhère à la couche de support (2) et aux sources lumineuses (1), sans laisser des vides d'air,
**caractérisé en ce que**
la couche de support (2) et la couche de couverture (4) sont réalisées avec des matériaux flexibles, de manière à pouvoir enrouler le lé (T) en un rouleau sans plis,
la couche de support (2) est réalisée en un matériau non transparent, et
la couche de couverture (4, 40) est réalisée en un matériau non transparent, mais qui permet la diffusion de la lumière, de manière à ne pas faire voir les sources lumineuses à un observateur, lorsque lesdites sources lumineuses sont éteintes, et faire percevoir à l'observateur l'effet lumineux des sources lumineuses lorsque les sources lumineuses sont allumées.

2. Lé (T) selon la revendication 1, **caractérisé en ce que** ladite couche de support (2) a une structure multicouches (2a, 2b).

3. Lé (T) selon l'une des revendications précédentes, **caractérisé en ce que** lesdites sources lumineuses (1) sont des diodes.

4. Lé (T) selon l'une des revendications 1 ou 2, **caractérisé en ce que** lesdites sources lumineuses (1) sont des fibres optiques.

5. Lé (T) selon l'une des revendications 1 ou 2, **caractérisé en ce que** lesdites sources lumineuses (1) sont des fils électroluminescents.

6. Lé (T) selon l'une des revendications précédentes, **caractérisé en ce que** ladite couche de revêtement (4) a une surface continue, substantiellement correspondante à celle de la couche de support (2) contre laquelle elle doit adhérer.

7. Lé (T) selon l'une des revendications de 1 à 5, **caractérisé en ce que** ladite couche de revêtement (40) a une surface discontinue, telle à recouvrir sélectivement seulement lesdites sources lumineuses (1) fixées sur la couche de support (2) correspondante.

8. Lé (T) selon l'une des revendications précédentes, **caractérisé en ce que** lesdites sources lumineuses (1) sont dotées de branchements électriques constitués de fibres en carbone ou titane qui forment un réticule de renforcement pour ledit lé (T).

9. Lé (T) selon l'une des revendications précédentes, **caractérisé en ce que** lesdites sources lumineuses (1) sont dotées de branchements électriques englobés entre ladite couche de revêtement (4) et ladite couche de support (2).

10. Lé (T) selon la revendication 9, en ce qu'elle dépend de la revendication 2, **caractérisé en ce que** lesdites sources lumineuses (1) sont dotées de branchements électriques englobés dans la structure multicouches de la couche de support (2).

11. Lé (T) selon l'une des revendications précédentes, **caractérisé en ce que** ladite couche adhésive (3) comprend des colles réactivables à chaud ou à froid à l'aide d'un catalyseur ou suite à l'exposition aux rayons UV.

12. Lé (T) selon l'une des revendications de 1 à 10, **caractérisé en ce que** ladite couche adhésive (3) est un collant réactivable avec l'exposition à l'air ou à la lumière.

13. Lé (T) selon l'une des revendications précédentes, **caractérisé en ce qu'**il comprend des moyens de fixation, tels que le Velcro, disposés sur la face postérieure de ladite couche de support (2) pour la fixation dudit lé ou bande.
